# EUROPÄISCHE PATENTSCHRIFT

(11) **EP 2 316 123 B1**
(45) Veröffentlichungstag und Bekanntmachung des Hinweises auf die Patenterteilung: **14.05.2014**
(21) Anmeldenummer: 08801509.4
(22) Anmeldetag: 01.08.2008
(51) Int. Cl.: H01J 37/34, C23C 14/34, C23C 16/515, C23C 14/35

(54) **ANORDNUNG UND VERFAHREN ZUR ERZEUGUNG EINES PLASMAS MIT DEFINIERTEM UND STABILEM IONISIERUNGSZUSTAND**
ARRANGEMENT AND METHOD FOR GENERATING A PLASMA HAVING A DEFINED AND STABLE IONIZATION STATE
DISPOSITIF ET PROCÉDÉ POUR GÉNÉRER UN PLASMA AVEC UN ÉTAT D'IONISATION DÉFINI ET STABLE

(43) Veröffentlichungstag der Anmeldung: 04.05.2011
(73) Patentinhaber: Fraunhofer-Gesellschaft zur Förderung der angewandten Forschung e.V., 80686 München (DE); Ifu Diagnostic Systems Gmbh, 09244 Lichtenau (DE)
(72) Erfinder: WALLENDORF, Till, 09112 Chemnitz (DE); BANDORF, Ralf, 31241 Ilsede (DE); VERGÖHL, Michael, 38162 Destedt (DE)
(74) Vertreter: Pfenning, Meinig & Partner GbR
(86) Internationale Anmeldenummer: PCT/EP2008/006373
(87) Internationale Veröffentlichungsnummer: WO 2010/012293

(56) Entgegenhaltungen:
- WO-A-03/079397
- WO-A-2008/071732
- DE-A1- 10 015 244
- DE-B3- 10 312 549
- US-A1- 2005 184 669

## Beschreibung

Die Erfindung betrifft einen Pulserzeuger für Sputteranlagen, mit welchem Pulse mit zumindest phasenweise konstantem Stromfluss erzeugbar sind sowie ein Verfahren zur Anregung und/oder Erzeugung eines Plasmas mit derartigen Pulsen. Die Erfindung betrifft auβerdem eine Sputteranlage.

Für viele Anwendungen ist es wünschenswert, Strompulse zur Verfügung zu haben, welche zumindest abschnittsweise eine im Wesentlichen konstante Stromstärke haben. Insbesondere ist es erwünscht, Pulse zur Verfügung zu haben, welche in einer Einschaltphase eine gewünschte Stromstärke in möglichst kurzer Zeit erreichen und diese dann in einer Konstantstromphase möglichst konstant halten. Vorteilhafterweise fällt der Strom nach dem Ende der Konstantstromphase in einer Ausschaltphase möglichst schnell wieder auf Null zurück.

Insbesondere bei Puls-Sputterverfahren sind solche Strompulse vorteilhaft. Für einen definierten Wachstumsprozess einer in einem solchen Puls-Sputterverfahren hergestellten Schicht ist es wünschenswert, die Eigenschaften eines in diesem Puls-Sputterverfahren erzeugten Plasmas möglichst genau einzustellen und möglichst stabil zu halten, da sich die Eigenschaften des Plasmas auf das Substrat und auf den Schichtbildungsprozess auswirken. Beim High-Puls-Power-Magnetron-Sputterprozess (HPPMS-Prozess) konnte der Einfluss der Eigenschaften des Plasmas auf die im Sputterprozess erhaltene Schichtstruktur nachgewiesen werden (Sittinger, Ruske, Szyszka, Wallendorf: Position and time resolved optical emission spectroscopy and film properties of ITO films deposited by high power pulsed magnetron sputtering, SVC proceedings 2006, 144-149).

Die Eigenschaften des Plasmas wiederum hängen vor allem vom Strom ab, welcher durch das Plasma fließt. Der Einfluss des Stroms lässt sich beispielsweise ermitteln, indem optische Emissionen des Plasmas in Abhängigkeit von dem durch das Plasma fließenden Strom ermittelt werden. Es zeigen sich bei derartigen Messungen der optischen Emissionen Schwellströme, die mit verschiedenen Spezies und Ionisierungszuständen von Ionen identifiziert werden können.

Eine mögliche Erklärung für die Entstehung dieser Schwellströme ist, dass mit zunehmenden Stromstärken nacheinander jeweils die optischen Emissionen von Teilchen mit zunehmender Ionisierungsstufe einsetzen. Bei niedrigen Stromstärken emittieren in dieser Vorstellung hauptsächlich neutrale Atome. Steigt die Stromstärke an, werden zunehmend Atome ionisiert, so dass die optische Emission einfach geladener Ionen einsetzt. Mit weiter steigender Stromstärke werden zunehmend auch Atome mehrfach ionisiert. Die jeweiligen Ionisationsstufen führen zum Auftreten der genannten Schwellströme.

In Puls-Sputterverfahren nach dem Stand der Technik wächst die Stromstärke, welche in die Entladung eingekoppelt wird, während eines Pulses stetig an, so dass während eines Plasmapulses der Zustand des Plasmas durchgestimmt wird. Dadurch durchlaufen die Atome während des Plasmapulses kontinuierlich mehrere Ionisierungszustände, so dass das Plasma zu jedem zeitpunkt unterschiedliche Eigenschaften hat. Hierdurch ändern sich die Wachstumsbedingungen für eine im Sputterverfahren aufgewachsene Schicht kontinuierlich, so dass der Schichtwachsprozess nur in engen Grenzen steuerbar ist.

Die DE 100 15 244 A1 beschreibt ein Verfahren und eine Schaltungsanordnung zur pulsförmigen Energieeinspeisung in Magnetronentladungen. Hierbei wird in jedem einzelnen Puls zwischen einer Zündquelle und einer Stromquelle umgeschaltet. Das Zünden des Plasmas erfolgt jeweils mittels einer Zündquelle mit der Charakteristik einer Spannungsquelle.

Die DE 103 12 549 B3 beschreibt ein Verfahren zur Erzeugung einer Ausgangsgleichspannung einer Gasentladungsprozess-Spannungsversorgungseinheit, bei dem in einer ersten Spannungswandlerstufe eine erste Gleichspannung in eine zweite Gleichspannung eines vorgegebenen Spannungsbereichs gewandelt wird, und in einer zweiten Spannungswandlerstufe, die Ausgangsgleichspannung aus der zweiten Gleichspannung erzeugt wird. Aufgabe der vorliegenden Erfindung ist es daher, einen Pulserzeuger anzugeben, mit welchem Strompulse mit zumindest während einem Teil der Dauer des Pulses konstanter und bestimmbarer Stromstärke erzeugbar sind. Aufgabe der vorliegenden Erfindung ist es auβerdem, ein Verfahren anzugeben, mit welchem ein Plasma mit derartigen Strompulsen erzeugbar und/oder anregbar ist. Aufgabe ist es auch, eine Sputteranlage anzugeben, mit der die Vorteile der Erfindung realisierbar sind.

Diese Aufgabe wird gelöst durch den Pulserzeuger für Sputteranlagen nach Anspruch 1 sowie das Verfahren zur Erzeugung und/oder Anregung eines Plasmas nach Anspruch 10 sowie die Sputteranlage nach Anspruch 15. Vorteilhafte Weiterbildungen des erfindungsgemäßen Pulserzeugers und des erfindungsgemä βen Verfahrens werden durch die jeweiligen abhängigen Ansprüche gegeben.

Erfindungsgemäß ist ein Pulserzeuger für Sputteranlagen, mit welchem während einer eine erste Zeit dauernden Einschaltphase ein möglichst schneller Anstieg eines durch den Pulserzeuger erzeugten Stroms an einem Ausgang des Pulserzeugers, also z.B. durch ein Plasma oder ein Gas, erzeugbar ist. Dadurch, dass der Anstieg der Stromstärke sehr kurz ist, werden im Sputterverfahren Plasmazustände, welche von dem gewünschten Plasmazustand abweichen, nur sehr kurz eingestellt. Der schnelle Stromanstieg während der Einschaltphase wird erfindungsgemäß erzielt, indem während der Einschaltphase eine erste Spannung über einen Ausgang des Pulserzeugers anlegbar ist, welche so groß ist, dass sie einen schnellen Anstieg der Stromstärke über den Ausgang des Pulserzeugers bewirkt.

Die erste Spannung dient also bevorzugt der Zündung des Plasmas mit möglichst sofortigem Übergang in die Stromanstiegsphase. Vorzugsweise sollte hier der Übergang über die niedrigen Stromstärken, also die Niedrigstromzustände rasch erfolgen, um die folgende Konstantstromphase möglichst schnell zu erreichen, in welcher bevorzugt ein maßgeblich konstanter Ionisierungszustand des Plasmas über eine gewisse Zeit hinweg aufrechterhalten werden soll.

Im Anschluss an die Einschaltphase ist mit dem erfindungsgemäßen Pulserzeuger in einer Konstantstromphase ein im Wesentlichen konstanter Strom erzeugbar, d.h. ein Strom mit während der Konstantstromphase im Wesentlichen konstanter Stromstärke. Dies wird erfindungsgemäß erreicht, indem eine zweite Spannung, welche kleiner ist als die genannte erste Spannung, über den Ausgang des Pulserzeugers anlegbar ist. Es können also Stromsignale mit unterschiedlichen Niveaus erzeugt werden. In das Plasma oder Gas kann also zeitweise ein konstanter Strom eingeprägt werden.

Die erste Spannung kann vorzugsweise so groß sein, dass in der ersten Zeit während der Einschaltphase der Strom am Ausgang des Pulserzeugers einen Betrag ≥ 1 A, vorzugsweise ≥ 10 A, vorzugsweise ≥ 50 A, vorzugsweise ≥ 200 A, vorzugsweise ≥ 400 A, vorzugsweise ≥ 500 A und/oder ≤ 1000 A, vorzugsweise ≤ 800 A, vorzugsweise ≤ 700 A, vorzugsweise ≤ 600 A erreicht und/oder die erste Spannung kann ≥ 300 V, vorzugsweise ≥ 400 V, vorzugsweise ≥ 500 V, vorzugsweise ≥ 600 V, vorzugsweise ≥ 700 V, vorzugsweise ≥ 800 V, vorzugsweise ≥ 900 V, vorzugsweise ≥ 1000 V, vorzugsweise ≥ 1100 V, vorzugsweise ≥ 1200 V sein, die zweite Spannung kann vorteilhaft ≤ 1200 V, vorzugsweise ≤ 1100 V, vorzugsweise ≤ 1000 V, vorzugsweise ≤ 900 V, vorzugsweise ≤ 800 V, vorzugsweise ≤ 700 V, vorzugsweise ≤ 600 V, vorzugsweise ≤ 500 V, vorzugsweise ≤ 400 V, vorzugsweise ≤ 300 V, vorzugsweise ≤ 200 V sein und/oder die zweite Spannung kann vorzugsweise ≥ 400 V, vorzugsweise ≥ 500 V sein und/oder die erste Zeit kann z.B. ≤ 200 µs, vorzugsweise ≤ 100 µs, vorzugsweise ≤ 50 µs, vorzugsweise ≤ 30 µs, vorzugsweise ≤ 20 µs, vorzugsweise ≤ 10 µs, vorzugsweise ≤ 5 µs sein.

Vorzugsweise ist der Pulserzeuger so ausgestaltet, dass die Einschaltphase und die Konstantstromphase unmittelbar aneinander angrenzend erzeugbar sind, so dass, nachdem der Strom in der Einschaltphase auf seinen Sollwert gebracht wurde, er in der Konstantstromphase einen konstanten Wert annimmt. Bevorzugt ist es hierbei, wenn die Stromstärke in der Konstantstromphase im Wesentlichen gleich der maximalen Stromstärke ist, welche in der Einschaltphase erreicht wird. Der Strom in der Konstantstromphase kann aber auch etwas unter oder über dem in der Einschaltphase erreichten Strom liegen. Ein solcher Fall kann insbesondere durch die Schaltverzögerung der eingesetzten Halbleiter verursacht werden, wobei eine Pause von < 5 µs, bevorzugt kürzer oder gleich 3 µs, besonders bevorzugt kürzer oder gleich 2 µs, besonders bevorzugt kürzer oder gleich 1 µs, besonders bevorzugt kürzer oder gleich 0,5 µs, besonders bevorzugt kürzer oder gleich 0,1 µs verantwortlich sein kann. Eine solche Pause zwischen der Stromanstiegsphase und der Konstantstromphase kann zu einer Abschwächung des Plasmas führen. Jedoch ist es vorteilhaft, wenn sie noch nicht zum deutlichen Verlöschen des Plasmas führt.

Vorzugsweise ist der in der Konstantstromphase eingestellte Strom jedoch so groß, dass sich der Zustand des Plasmas während der Konstantstromphase vom Zustand, der in der Einschaltphase durch den dort maximal erreichten Strom eingestellt wurde, nicht oder nicht wesentlich unterscheidet. Insbesondere ist es vorteilhaft, wenn zwischen der Einschaltphase und der Konstantstromphase das Plasma nicht erlischt. Bevorzugterweise überlappen sich aufeinander folgende Pulse und/oder aufeinander folgende Phasen je eines Pulses nicht.

Vorzugsweise ist mit dem Pulserzeuger ein Puls erzeugbar, der zumindest vier Phasen aufweist. Zum einen weist der mit dem Pulserzeuger erzeugbare Puls die oben genannte Einschaltphase und Konstantstromphase auf. Vorzugsweise schließt sich an die Konstantstromphase eine Ausschaltphase an, in welcher die Stromstärke in möglichst kurzer Zeit von ihrem in der Konstantstromphase angenommenen Wert auf Null oder einen Ausgangswert absinkt. Besonders bevorzugt schließt sich die Ausschaltphase an die Konstantstromphase unmittelbar an. Bevorzugt ist außerdem, dass sich an die Ausschaltphase eine Kühlphase anschließt, in welcher kein Plasma und/oder kein Stromfluss vorliegt, so dass sich ein Target der Sputtervorrichtung abkühlen kann.

Es ist bevorzugt, wenn die genannte Einschaltphase möglichst kurz ist, d.h. vorzugsweise kürzer oder gleich 200 µs, vorzugsweise kürzer oder gleich 100 µs, vorzugsweise kürzer oder gleich 50 µs, vorzugsweise kürzer oder gleich 30 µs, besonders bevorzugt kürzer oder gleich 20 µs, besonders bevorzugt kürzer oder gleich 10 µs, besonders bevorzugt kürzer oder gleich 5 µs. Die Konstantstromphase wird vorzugsweise maximal so lang gewählt, dass thermische Prozesse, wie beispielsweise eine Aufheizung der Targetoberfläche, nicht zu einer ungewollten Änderung des Plasmazustands führen. Entsprechend wird die Kühlphase vorzugsweise so lange gewählt, dass sich das Target so stark abkühlen kann, dass durch seine Temperatur der Sputterprozess nicht beeinflusst wird. Besonders bevorzugt wird die Kühlphase so lange gewählt, dass das Target oder die Targetoberfläche während der Kühlphase bis auf jene Temperatur abkühlt, welche vor Beginn der vorausgegangenen Einschaltphase oder zu Beginn des Sputterprozesses vorlag.

Der Pulserzeuger wird wie folgt realisiert. In einer möglichen Ausgestaltung weist der Pulserzeuger vorzugsweise zumindest zwei Gleichspannungserzeugungsvorrichtungen auf. Derartige Gleichspannungserzeugungsvorrichtungen können Gleichspannungsquellen, wie beispielsweise DC-Netzteile sein, es sollen aber auch Spannungswandler in Verbindung mit einer Kapazität als Gleichspannungserzeugungsvorrichtung angesehen werden.

Erfindunggemäß sind beide Gleichspannungserzeugungsvorrichtungen Gleichspannungsquellen.

Alternativ kann jedoch auch eine der Gleichspannungserzeugungsvorrichtungen eine Gleichspannungsquelle sein und die andere der Gleichspannungserzeugungsvorrichtungen ein Spannungswandler, welcher mit zumindest einer Kapazität in Kontakt ist. Derartige Spannungswandler werden beispielsweise als Baugruppe in BOOST DC/DC-Spannungswandlern eingesetzt. Die aus dieser Baugruppe ausgekoppelte Energiemenge wird zur initialen Erzeugung der für die beabsichtigte Stromtragfähigkeit des Plasmas benötigte Ladungsträgerdichte im Plasma verwendet. Diese Energie bzw. Leistung ist nach dieser Maßgabe vorzugsweise deutlich geringer als die Energie bzw. Leistung, die während des Konstantstrompulses umgesetzt wird. Es handelt sich demnach vorzugsweise nur um eine Zündhilfe für den nachfolgenden Konstantstrompuls. Mit Hilfe des Spannungswandlers wird also die genannte erste Spannung erzeugt, die während der Einschaltphase anliegt.

Der Spannungswandler in Verbindung mit der Kapazität kann hier als Gleichspannungsquelle angesehen werden. Die Kapazität kann zunächst mit einem Spannungspuls aufgeladen werden und danach mittels eines Schalters an die Plasmaquelle angeschlossen werden, um die Einschaltphase zu erzeugen.

Die Leistungsversorgung des Pulserzeugers kann beispielsweise durch ein externes DC-Netzteil mit einem AC-Eingang erfolgen.

Vorzugsweise speist die Gleichspannungsquelle, vorzugsweise über eine Strombegrenzerschaltung, einen Kondensator C1 als erstem Kondensator. Hierdurch kann eine Pulsbelastung des DC-Netzteils verhindert werden. Aus der über den Kondensator C1 aufgebauten Spannung wird mittels des Spannungswandlers eine Spannung erzeugt, die am zweiten Kondensator C2 abfällt und diesen lädt. Die in den Kondensatoren C1 und C2 gespeicherten Ladungen und/oder Energiemengen können über einen Schalter S2 (z.B. dem oben genannten erste oder zweiten Schalter) sowie vorzugsweise auch einen Messumformer T1 auf einen Ausgang des Pulserzeugers und damit auf das Plasma geleitet werden.

In einer Ausgestaltung der Erfindung kann hier das DC-Netzteil mit nachfolgender Kondensatorspeicherung die Energie aufbringen, die für die Aufrechterhaltung des Pulsstromes benötigt wird. Ein zweites DC-Netzteil oder alternativ ein Pulswandler kann genutzt werden, um den Zustand der Konstantstromphase überhaupt zu erreichen.

Die Leistung kann also durch ein DC-Netzteil jeglicher Bauart bereitgestellt werden und die Konstanz des Pulsstromes kann über die eingestellte DC-Spannung herbeigeführt werden.

Ein erster Schalter ist also hinter dem Ausgang der ersten Gleichspannungserzeugungsvorrichtung angeordnet bzw. so angeordnet, dass durch Schließen des ersten Schalters der Ausgang der ersten Gleichspannungserzeugungsvorrichtung mit dem Ausgang des Pulserzeugers verbindbar ist. Der zweite Schalter ist vorzugsweise hinter dem Ausgang der zweiten Gleichspannungserzeugungsvorrichtung angeordnet und/oder so angeordnet, dass durch Schließen des zweiten Schalters der Ausgang der zweiten Gleichspannungserzeugungsvorrichtung mit dem Ausgang des Pulserzeugers verbindbar ist. Vorzugsweise werden eine oder beide der Spannungserzeugungsvorrichtungen sowie die Schalter des Pulserzeugers durch eine Steuervorrichtung gesteuert. Diese Steuerung erfolgt vorzugsweise so, dass die erzeugten Pulse die oben beschriebenen Eigenschaften aufweisen.

Besonders bevorzugt ist es, dass am oder im Pulserzeuger ein oder mehrere Messvorrichtungen angeordnet sind, die Messgrößen, welche einen Betriebszustand des Pulserzeugers wiedergeben, messen. Darüberhinaus weist der Pulserzeuger vorzugsweise ein oder mehrere Messvorrichtungen auf, die einen Zustand des erzeugten Plasmas anzeigen.

Bevorzugt ist es hier, wenn zumindest ein Strommessgerät in direkter elektrischer Verbindung mit einer Anode oder Kathode des Ausgangs des Pulserzeugers angeordnet ist, mit welchem der durch das Plasma flieβende Strom messbar ist. Weiter ist es bevorzugt, wenn parallel zur Strecke Kathode-Anode ein Spannungsmessgerät angeordnet ist, mit welchem die über den Ausgang des Pulserzeugers, d.h. zwischen Kathode und Anode, abfallende Spannung messbar ist. Es ist außerdem bevorzugt, wenn eine Messvorrichtung optische Strahlung, die das von dem Pulserzeuger erzeugte Plasma aussendet, misst. Als solche optische Messvorrichtung ist insbesondere eine Vorrichtung geeignet, mit der ein Spektrum der vom Plasma ausgesandten Strahlung zumindest bereichsweise aufnehmbar ist.

Vorzugsweise werden zumindest einige der von den Messvorrichtungen aufgenommenen Messwerte zur Steuerung des Pulserzeugers verwendet.

Als Steuerung eignet sich besonders, und ist daher bevorzugt, eine intelligente Logik-Schaltung sowie eine Vorrichtung, mit welcher Messwerte rechnerisch oder durch Verschaltung in Steuerwerte zum Steuern zumindest eines Elements des Pulserzeugers umwandelbar sind. Vorzugsweise werden Signale der Messvorrichtungen so schnell für die gesamte Dauer eines Stromimpulses umgeformt, dass die Messdaten den aktuellen Stromverlauf auch während des Pulses wiedergeben.

Weitere mögliche Messvorrichtungen sind beispielsweise elektrische Anlaufsonden, Langmuir-Sondenmessgeräte, zeitauflösende Massenspektrometer und/oder laserinduzierte Fluoreszenzmessgeräte. Aufnehmbare Messgrößen können beispielsweise auch Potentiale in der Plasmakammer, wie beispielsweise Substratpotentiale, Anodenpotentiale und/oder Steuerelektrodenpotentiale sein. Desweiteren können weitere Stromquellen innerhalb und/oder außerhalb der Plasmakammer zeitabhängig angesteuert werden, so beispielsweise auch Pulsstromquellen zur Erzeugung von Magnetfeldern.

In einer möglichen Ausgestaltungsform der Erfindung können auch negative unipolare Konstantstrompulse, also Konstantstrompulse mit umgekehrten Vorzeichen erzeugt werden. Bei Umpolung auftretender Dioden und elektronischer Schalter kann hierbei dieselbe Anordnung wie zur Erzeugung eines positiven unipolaren Stromimpulses zum Einsatz kommen. Für einen umgekehrt gepolten unipolaren Strom wird vorzugsweise auch das Magnetron oder die Plasmakammer in umgekehrter Polarität angeschlossen, so dass die Anode mit dem positiven Ausgang und die Kathode mit dem negativen Ausgang des Pulserzeugers verbunden werden. Eine Umpolung der Spannung am Ausgang des Pulserzeugers ist auch mittels eines Umpolschalters erzielbar, der vor dem Ausgang des Pulserzeugers angeordnet ist.

Der erfindungsgemäße Pulserzeuger und das erfindungsgemäße Verfahren zur Erzeugung von Pulsen kann in allen Arten von Puls-Sputtervorrichtungen bzw. Puls-Sputterverfahren zum Einsatz kommen. Besonders geeignet sind der Pulserzeuger und das Verfahren zur Pulserzeugung für High-Puls-Power-Magnetron-Sputtervorrichtungen, beispielsweise mit Titan-Target. Andere mögliche Targets sind ITO, Kohlenstoff und andere gängige Targetmaterialien.

Bevorzugt geht die Einschaltphase bzw. Anstiegsphase direkt ohne Zwischenpause in die Konstantstromphase über. Dies kann unter anderem durch Software, Firmware und/oder FPGA-Programme gesteuert werden. Eine gegebene Hardware könnte dann mit spezieller Software und/oder Firmware und/oder FPGA-Programm gesteuert werden.

Die Erfindung beschreibt eine Anordnung und ein Verfahren für stabile Plasmabedingungen, bei denen das Erreichen einer hohen Rate gegebenenfalls sogar den möglichst stabilen Plasmabedingungen geopfert werden kann, indem ein Abschalten vor dem Eintreten von thermischen Target-Effekten durchgeführt wird. Daher sind auch relativ kurze Pulszeiten in der Größenordnung einiger hundert Mikrosekunden bevorzugt.

Im folgenden soll die Erfindung anhand einiger Figuren beispielhaft näher erläutert werden. Die in den Figuren gezeigten Merkmale können in der erfindungsgemäßen Vorrichtung und dem erfindungsgemäßen Verfahren auch einzeln mit entsprechender Funktion realisiert sein.

Es zeigt
- Figur 1: einen erfindungsgemäßen Pulserzeuger,
- Figur 2: einen erfindungsgemäßen Pulserzeuger mit umschaltbarer Polarität am Ausgang,
- Figur 3: ein idealisiertes Strom- und Spannungsprofil, wie es durch den erfindungsgemäβen Stromerzeuger und das erfindungsgemäβe Verfahren erzeugbar ist und
- Figur 4: ein Beispiel einer mit dem Pulserzeuger am Ausgang erzeugten Spannung und eines hierdurch erzeugten Stroms.

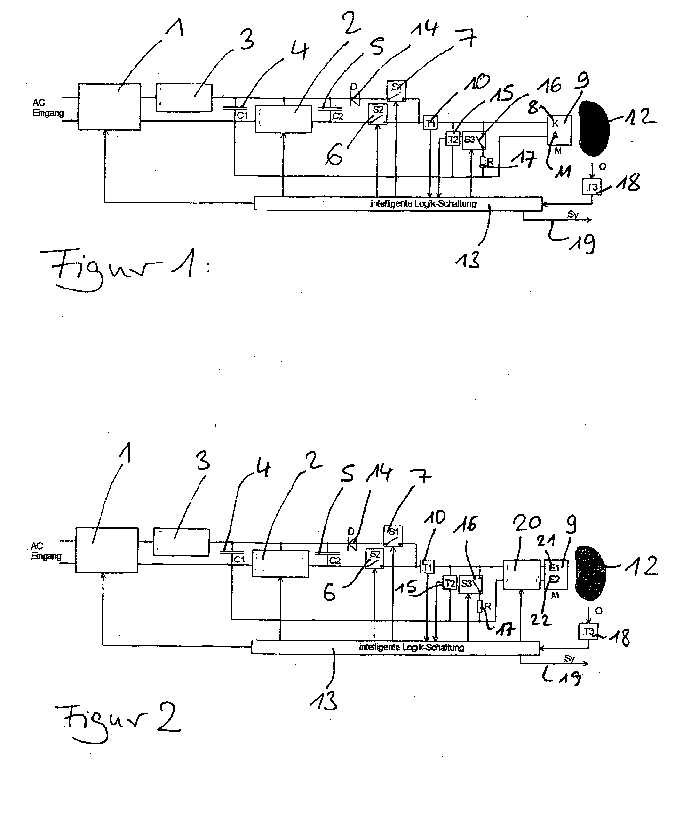

Figur 1 zeigt einen erfindungsgemäßen Pulserzeuger mit zwei Gleichspannungserzeugungsvorrichtungen 1 und 2, wobei eine Gleichspannungserzeugungsvorrichtung ein DC-Netzteil 1 ist und die andere Gleichspannungserzeugungsvorrichtung ein Spannungswandler 2. Am Gleichspannungsausgang des DC-Netzteils 1 ist ein Strombegrenzer 3 angeordnet, der eine Pulsbelastung des DC-Netzteils 1 verhindert. Parallel zum Gleichspannungsausgang des DC-Netzteils 1 ist ein Kondensator C1 4 angeordnet, der mittels der durch das DC-Netzteil 1 erzeugten Spannung ladbar ist.

Der Spannungswandler 2 erzeugt aus der über dem Kondensator 4 aufgebauten Spannung eine Spannung, welche über einem zweiten Kondensator C2 5 abfällt und diesen lädt. Zwischen dem Ausgang des Spannungswandlers 2 sowie einem Pol des Kondensators 5 und andererseits einer Kathode 8 eines Ausgangs 9 des Pulserzeugers ist ein Schalter S2 6 angeordnet. Wird der Schalter 6 geschlossen, so wird zumindest ein Teil der in den Kondensatoren 4 und 5 gespeicherten Ladung bzw. Energiemengen über den Schalter 6 zur Kathode 8 des Ausgangs 9,des Pulserzeugers geleitet. Zwischen dem Schalter 6 und der Kathode 8 kann hierbei ein Messumformer 10 angeordnet sein, mit welchem der in die Kathode fließende Strom messbar ist.

Am Ausgang 9 des Pulserzeugers fällt zwischen der Kathode 8 und einer Anode 11 effektiv die Summe der über den Kondensatoren 4 und 5 abfallenden Spannungen ab. Dies führt zu einem schnellen Stromanstieg im Plasma 12. Der schnelle Stromanstieg kann mittels des Messumformers T1 10 in ein digitales Signal umgewandelt werden und an eine Mess- und/oder Steuervorrichtung 13 übermittelt werden. Die Umwandlung des aktuellen Strompegels in ein entsprechendes Messsignal durch den Messumformer 10 erfolgt vorzugsweise so schnell, dass eine zuverlässige Erkennung der aktuellen Stromstärke und der erreichten Stromstärke noch während er Einschaltphase erfolgt. Zwischen jenem Kontakt des Kondensators 5, welcher nicht mit dem Schalter 6 verbunden ist, und der Kathode 8 des Ausgangs 9 des Pulserzeugers ist nun ein weiterer Schalter 7 angeordnet. Hierbei ist zwischen diesem Anschluss des Kondensators 5 und des Schalters 7 außerdem eine Diode D 14 angeordnet, die in Richtung vom Schalter 7 zum Anschluss des Kondensators 5 durchlässig ist. Ist nun am Ende der Einschaltphase der gewünschte Strompegel in die Kathode 8 erreicht, so wird der Schalter 6 geöffnet und der Schalter 7 geschlossen, so dass nunmehr nur noch die kleinere über dem Kondensator 4 abfallende Spannung am Ausgang 9 des Pulserzeugers anliegt. Das Öffnen des Schalters 6 und das Schließen des Schalters 7 markieren also den Übergang von der Einschaltphase zur Konstantstromphase. Die Diode 14 dient hierbei der Vermeidung eines rückfließenden Stroms im Schalter 6 oder 7. Über den Schalter 7 kann also ausschließlich der Entladestrom des Kondensators 5 fließen. Die Anode 11 des Ausgangs 9 ist hierbei mit dem Widerstand 17, jener der Diode 14 abgewandten Seite des Kondensators 4 und dem Ausgang des DC-Netzteiles verbunden.

Vorzugsweise wird der Entladestrom in die Kathode 8 konstant gehalten, indem die Ausgangsspannung des DC-Netzteils 1 anhand des vom Messumformer 10 ermittelten aktuellen Stromflusses geregelt wird. Diese Regelung kann beispielsweise erfolgen, indem die Messwerte des Messumformers 10 von der Steuervorrichtung 13 aufgenommen werden und diese anhand der aufgenommenen Werte das Netzteil 1 steuert.

Der Pulserzeuger kann einen weiteren Messumformer T2 15 aufweisen, mit welchem die zwischen Kathode 8 und Anode 11 des Eingangs 9 des Pulserzeugers abfallende Spannung gemessen wird. Auch die so gemessenen Spannungen können von der Steuervorrichtung 13 ausgewertet werden und zur Steuerung des Netzteils 1 sowie der Schalter 6 und 7 verwendet werden.

Durch ein Öffnen des Schalters 7 wird die Konstantstromphase beendet.

Hiermit beginnt die Ausschaltphase. Ist der Strom am Ende der Ausschaltphase abgeklungen, beginnt automatisch die Kühlphase, während derer Teile des Pulserzeugers oder der gesamte Pulserzeuger abkühlt. Darüberhinaus können während der Kühlphase die Kondensatoren 4 und 5 nachgeladen werden.

Vorzugsweise weist der Pulserzeuger einen weiteren Schalter S3 16 auf, mit welchem die Kathode 8 und die Anode 11 über einen Widerstand R 17 kurzgeschlossen werden können, so dass sich die Elektrodenkapazität der Sputtervorrichtung entladen kann. Hierdurch wird ein Zündprozess des Plasmas durch wiederholtes wechselseitiges Einschalten des Schalters 7 bei geöffnetem Schalter 16 sowie Schließen des Schalters 16 bei geöffnetem Schalter 7 ermöglicht, ohne dass eine bipolare Anordnung notwendig wäre.

Vorzugsweise weist der Pulserzeuger außerdem einen Messumformer T3 18 auf, mit welchem vom Plasma 12 ausgesandte Strahlung, vorzugsweise optischer Strahlung, untersuchbar und in entsprechende Messsignale umwandelbar ist. Die durch den Messumformer 18 gemessenen Werte können dann wieder der Steuervorrichtung 13 übermittelt werden, welche das DC-Netzteil 1, den Spannungswandler 2, den Schalter 6, den Schalter 7 und/oder den Schalter 16 anhand der Messwerte steuert. Bevorzugterweise ist die Messvorrichtung 18 ein schneller optischer Detektor, der in der Lage ist, auf mehreren Spektralbereichen, bevorzugterweise in Bereichen, auf denen Atome und Ionen in der Plasmaentladung charakteristische optische Strahlung emittieren, optische Strahlung in geeignete elektrische Signale, vorzugsweise in digitale Signale zu überführen. Weiter kann die Steuervorrichtung 13, welche eine intelligente Logikschaltung 13 sein kann, zumindest einen weiteren Synchronimpuls 19 ausgeben, der dazu verwendet werden kann, weitere Dignostikgeräte oder Pulsquellen synchron anzusteuern.

Figur 2 zeigt einen Pulserzeuger, welcher dem in Figur 1 gezeigten entspricht. Insbesondere bezeichnen gleiche Bezugszeichen entsprechende Komponenten wie in Figur 1. Der in Figur 2 gezeigte Pulserzeuger unterscheidet sich von jenem im Figur 1 gezeigten dadurch, dass unmittelbar vor dem Ausgang 9 des Pulserzeugers ein Umpolschalter 20 angeordnet ist, mit welchem die Polarität der Elektrodenanschlüsse 21 und 22 des Ausgangs 9 umpolbar sind. Durch Umschalten des Schalters 20 können also Kathode 8 und Anode 11 vertauscht werden.

Sowohl in Figur 1 als auch in Figur 2 kann anstelle des Spannungswandlers 2 auch ein weiteres DC-Netzteil oder eine andere Spannungsquelle zum Einsatz kommen.

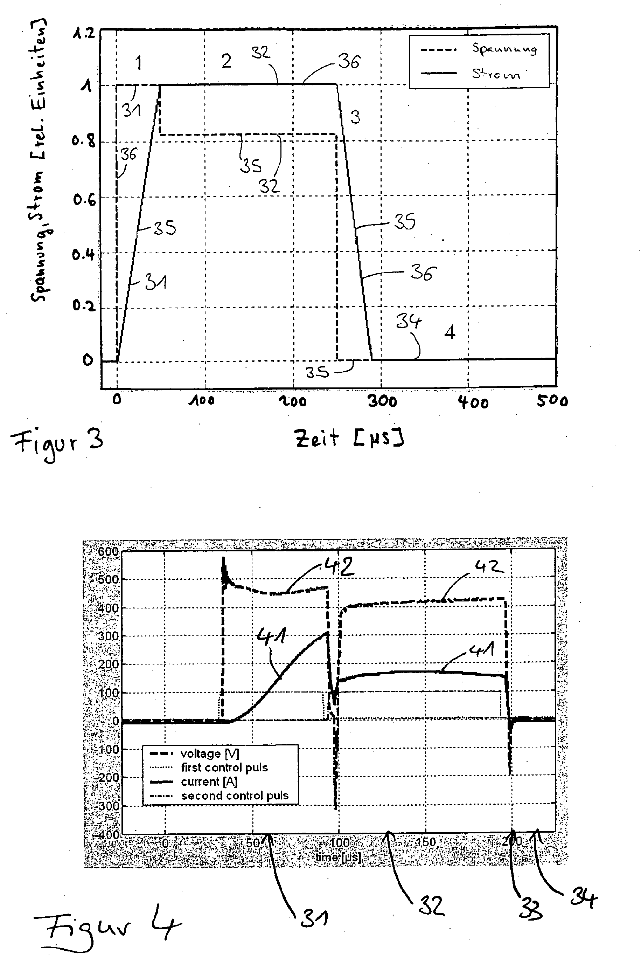

Figur 3 zeigt modellhaft ein Beispiel für den Verlauf eines Stroms 36 und einer Spannung 35 in einem Puls in relativen Einheiten in Abhängigkeit von einer Zeit in willkürlichen Einheiten. Hierbei ist der Strom und die Spannung auf der vertikalen Achse und die Zeit auf der horizontalen Achse aufgetragen. Im gezeigten Verlauf des Stromes 36 und der Spannung 35 sind die oben genannten Phasen des Pulses deutlich zu erkennen. Während der Einschaltphase 31 wird die Spannung auf den Wert 1 in willkürlichen Einheiten eingeschaltet. Während dieser Einschaltphase 31 steigt der Strom von 0 auf einen Wert 1, auf welchem er während der konstanten Stromphase 32 konstant gehalten wird. Die Einschaltphase 31 sollte hierbei möglichst kurz gewählt werden. Während der Konstantstromphase 32 wird eine Spannung 35 mit einem Wert von 0,82 angelegt. Die Länge der Konstantstromphase 32 wird vorzugsweise maximal so lange gewählt, dass thermische Prozesse, wie beispielsweise eine Aufheizung der Target-Oberfläche, noch nicht zu einer ungewollten Änderung des Plasmazustands führen. Im Anschluss an die Konstantstromphase 32 wird die Spannung 35 auf 0 gesetzt. Der Strom sinkt während der Ausschaltphase 33 möglichst schnell auf den Wert zurück, welchen er vor Beginn der Einschaltphase 31 hatte. Hier wird er dann während der Kühlphase 34 bis zur nächsten Einschaltphase 31 gehalten. Die Kühlphase 34 wird vorzugsweise so lange gewählt, dass das Target oder die Target-Oberfläche und/oder andere Teile der Sputtervorrichtung sich hinreichend abkühlen, vorzugsweise bis auf jene Temperatur, welche sie vor Beginn der vorausgegangenen Einschaltphase oder zu Beginn der Plasmaerzeugung hatten. Die angelegte Spannung 35 ist während der Kühlphase 34 im gezeigten Beispiel 0.

Figur 4 zeigt eine Messung eines mit einem erfindungsgemäßen Pulserzeuger erzeugten Stroms 41 durch den Ausgang 9 des Pulserzeugers und die dazugehörige Spannung 42. Während der Einschaltphase 31 wird die Spannung 42 zunächst auf einen ersten Wert eingeschaltet. Hierdurch ergibt sich ein Anstieg des Stroms 41 während der Einschaltphase 31. Der Anstieg des Stroms 41 endet am Ende der Einschaltphase 31, wenn die Spannung 42 auf einen zweiten Wert, der geringer ist als der erste Wert während der Einschaltphase 31 herabgesetzt wird. Dieses ist die Konstantstromphase 32. Es ist zu erkennen, dass während der Konstantstromphase 32 der Strom 41 einen im Wesentlichen konstanten Wert hat. Der konstante Wert kann während der Konstantstromphase 32 hierbei insbesondere dadurch unterstützt werden, dass bestimmte Werte, wie beispielsweise der Strom, während des Pulses gemessen werden und mittels der Steuervorrichtung 13 die Spannung 42 angepasst wird. Auf die Konstantstromphase 32 folgt die Ausschaltphase 33, während welcher die Spannung auf ihren ursprünglichen Wert herabgesetzt wird, welchen sie vor Beginn der Einschaltphase 31 hatte. Dieses Herabsetzen der Spannung führt zu einem schnellen Abfall des Stroms. Auf die Ausschaltphase 33 folgt die oben beschriebene Abkühlphase 34, während derer im gezeigten Beispiel sowohl Strom als auch Spannung den Wert 0 haben.

## Patentansprüche

1. Pulserzeuger für Sputteranlagen, mit dem ein elektrischer Puls erzeugbar ist, in dessen Verlauf während einer eine erste Zeit dauernden Einschaltphase ein schneller Anstieg eines durch den Pulserzeuger an einem Ausgang des Pulserzeugers erzeugten Stroms durch ein Plasma oder ein Gas erzeugbar ist, indem während der Einschaltphase eine erste Spannung über den Ausgang des Pulserzeugers anlegbar ist, und in einer auf die Einschaltphase folgenden Konstantstromphase ein im wesentlichen konstanter Strom durch das Plasma oder Gas am Ausgang des Pulserzeugers erzeugbar ist, indem eine zweite Spannung, welche betragsmäßig kleiner als die erste Spannung ist, über den Ausgang (9) des Pulserzeugers und an Eingänge einer Plasmaquelle anlegbar ist,
**dadurch gekennzeichnet,**
**dass** zur Erzeugung des Pulses ein Ausgang einer ersten Gleichspannungsquelle (1) und ein Ausgang einer zweiten Gleichspannungsquelle (2, 4) mit dem Ausgang des Pulserzeugers gesteuert verbindbar sind.

2. Pulserzeuger nach Anspruch 1, weiter **dadurch gekennzeichnet, dass** nach der Konstantstromphase, vorzugsweise unmittelbar nach der Konstantstromphase oder nach einer auf die Konstantstromphase, vorzugsweise unmittelbar, folgenden Ausschaltphase, und vor einer nächsten Einschaltphase eine Abkühlphase erzeugbar ist, in der kein Strom durch das Plasma oder Gas fließt und/oder dass zwei oder mehr aufeinander folgende Pulse mit einer Einschaltphase, einer Konstantstromphase und vorzugsweise einer Ausschaltphase und/oder einer Abkühlphase erzeugbar sind.

3. Pulserzeuger nach einem der vorhergehenden Ansprüche, weiter **gekennzeichnet dadurch, dass** die zweite Gleichspannungserzeugungsquelle ein Spannungswandler (2) in Verbindung mit einer Kapazität (4) ist.

4. Pulserzeuger nach einem der vorhergehenden Ansprüche, weiter **gekennzeichnet durch** zumindest eine Kapazität, welche parallel geschaltet zu einem Ausgang der ersten Gleichspannungsquelle angeordnet ist, wobei vorzugsweise die Kapazität zumindest einen Kondensator (4) aufweist oder ein Kondensator ist
und/oder
**durch** zumindest eine Kapazität, welche parallel geschaltet zu einem zweiten Ausgang der zweiten Gleichspannungsquelle angeordnet ist, wobei die Kapazität vorzugsweise zumindest einen Kondensator (5) aufweist oder ein Kondensator ist.

5. Pulserzeuger nach einem der Ansprüche 3 oder 4, weiter **dadurch gekennzeichnet, dass** ein Eingang des Spannungswandlers (2) parallel zu einem Ausgang der ersten Gleichspannungsquelle geschaltet ist.

6. Pulserzeuger nach einem der Ansprüche 3 bis 5, weiter **gekennzeichnet durch** zumindest einen Strombegrenzer (3), welcher unmittelbar am Ausgang der ersten Gleichspannungsquelle angeordnet ist.

7. Pulserzeuger nach einem der vorhergehenden Ansprüche, weiter **gekennzeichnet durch** einen ersten Schalter (7), welcher hinter einem Ausgang der ersten Gleichspannungsquelle angeordnet ist und/oder so angeordnet ist, dass durch Schließen des ersten Schalters der Ausgang der ersten Gleichspannungserzeugungsvorrichtung mit dem Ausgang des Pulserzeugers verbindbar ist
und/oder
**durch** einen zweiten Schalter (6), welcher hinter dem Ausgang der zweiten Gleichspannungsquelle angeordnet ist und/oder so angeordnet ist, dass **durch** Schließen des zweiten Schalters der Ausgang der zweiten Gleichspannungserzeugungsvorrichtung mit dem Ausgang des Pulserzeugers verbindbar ist
und/oder
**durch** einen dritten Schalter (16), welcher zwischen der Anode (11) und der Kathode (8) des Ausgangs des Pulserzeugers so angeordnet ist, dass die Anode und die Kathode über den dritten Schalter elektrisch miteinander verbindbar sind, wobei vorzugsweise der dritte Schalter mit zumindest einem Widerstand (17) in Reihe geschaltet ist, über welchen die Anode und die Kathode **durch** Schließen des dritten Schalters verbindbar sind
und/oder
**durch** zumindest einen Umpolschalter (20) zwischen der Anode und der Kathode des Ausgangs des Pulserzeugers, mit welchem die Spannung zwischen der Anode und der Kathode umpolbar ist.

8. Pulserzeuger nach einem der vorhergehenden Ansprüche, weiter **gekennzeichnet durch** zumindest eine Strommessvorrichtung (10), welche vor einer Anode und/oder vor einer Kathode des Ausgangs des Pulserzeugers so angeordnet ist, dass mit ihr eine Stromstärke **durch** die Anode und/oder die Kathode messbar ist
und/oder
**durch** zumindest eine Spannungsmessvorrichtung (15), welche so zwischen der Anode und der Kathode des Ausgangs des Pulserzeugers angeordnet ist, dass mit der Spannungsmessvorrichtung eine Spannung zwischen der Anode und der Kathode des Ausgangs des Pulserzeugers messbar ist
und/oder
**durch** zumindest eine Emissionsmessvorrichtung (18), welche so eingerichtet und/oder angeordnet ist, dass mit ihr elektromagnetische Strahlung, vorzugsweise optische Strahlung, messbar ist, die **durch** ein mittels des Pulserzeugers erzeugtes Plasma emittiert wird.

9. Pulserzeuger nach einem der vorhergehenden Ansprüche, weiter **gekennzeichnet durch** zumindest eine Steuervorrichtung (13), mit welcher eines oder mehrere Elemente ausgewählt aus der Gruppe aufweisend den ersten Schalter, den zweiten Schalter, den dritten Schalter, die erste Gleichspannungserzeugungsvorrichtung und die zweite Gleichspannungserzeugungsvorrichtung steuerbar ist, vorzugsweise, indem mit der Steuervorrichtung zumindest ein Synchronimpuls erzeugbar ist, mit welchem das oder die entsprechenden Elemente steuerbar sind, und **durch** zumindest eine Messvorrichtung (10, 15, 18) mit welcher zumindest eine Messgröße der Strommessvorrichtung, der Spannungsmessvorrichtung und/oder der Emissionsmessvorrichtung aufnehmbar ist, wobei vorzugsweise zumindest ein Element mit der Steuervorrichtung basierend auf zumindest einer der von der Messvorrichtung aufgenommenen Messgrößen steuerbar ist.

10. Verfahren zur Anregung und/oder Erzeugung eines Plasmas durch zumindest einen elektrischen Puls, wobei in einer eine erste Zeit dauernden Einschaltphase an das Plasma oder ein Gas zur Erzeugung des Plasmas eine erste Spannung zur Erzeugung eines schnellen Anstiegs der Stärke eines Stroms durch das Plasma angelegt wird, und wobei in einer auf die Einschaltphase folgenden Konstantstromphase an das Plasma eine zweite Spannung, die betragsmäßig kleiner ist als die erste Spannung zur Erzeugung eines im Wesentlichen konstanten Stroms durch das Plasma angelegt wird, **dadurch gekennzeichnet, dass** zur Erzeugung des Pulses ein Ausgang einer ersten Gleichspannungsquelle und ein Ausgang einer zweiten Gleichspannungsquelle mit dem Ausgang des Pulserzeugers gesteuert verbunden werden.

11. Verfahren nach einem der beiden vorhergehenden Ansprüche, weiter **dadurch gekennzeichnet, dass** die Konstantstromphase unmittelbar auf die Einschaltphase folgt oder dass zwischen der Einschaltphase und der Konstantstromphase eine Zeit von maximal 100 µs, vorzugsweise maximal 50 µs, vorzugsweise maximal 30 µs, vorzugsweise maximal 20 µs, vorzugsweise maximal 10 µs, vorzugsweise maximal 5 µs verstreicht.

12. Verfahren nach einem der Ansprüche 10 und 11, weiter **dadurch gekennzeichnet, dass** die Konstantstromphase nur so lange dauert, dass eine Temperaturerhöhung oder eine ungewollte Temperaturerhöhung während der Konstantstromphase im Wesentlichen nicht zu einer Veränderung des Plasmas führt und/oder dass die Ausschaltphase möglichst kurz ist, vorzugsweise kürzer als oder gleich lang wie die Einschaltphase.

13. Verfahren nach einem der Ansprüche 10 bis 12, weiter **dadurch gekennzeichnet, dass** zwischen je zwei Pulsen eine Kühlphase, während derer keine Spannung an das Plasma oder das Gas zur Erzeugung des Plasmas angelegt wird, und während derer kein Strom durch das Plasma fließt, ausgeführt wird, wobei die Dauer der Kühlphase vorzugsweise so gewählt wird, dass eine Targetoberfläche, von welcher gesputtert wird, am Ende der Kühlphase eine Temperatur hat, die im Wesentlichen gleich oder genau gleich der Temperatur der Targetoberfläche unmittelbar vor Beginn der vorangegangenen Einschaltphase ist.

14. Verfahren nach einem der Ansprüche 10 bis 13, weiter **dadurch gekennzeichnet, dass** das Verfahren in einem Pulssputterverfahren, vorzugsweise in einem High-Power-Pulse-Magnetron-Sputter-Verfahren bzw. Hochleistungspuls-Magnetronsputterverfahren (HPPMS-Verfahren) durchgeführt wird und/oder dass eine Vielzahl von Pulsen erzeugt wird.

15. Sputteranlage, **gekennzeichnet durch** einen Pulserzeuger nach einem der Ansprüche 1 bis 9 und/oder **dadurch** gekennzeichnet, dass mit ihr ein Verfahren nach einem der Ansprüche 10 bis 14 durchführbar ist.

## Claims

1. Pulse generator for sputtering facilities, with which an electrical pulse can be generated, in the course of which, during a switch-on phase lasting for a first time, a rapid increase in the current through a plasma or a gas generated by the pulse generator at the output of the pulse generator can be generated by, during the switch-on phase, a first voltage being able to be applied via the output of the pulse generator, and, in a constant current phase following the switch-on phase, an essentially constant current through the plasma or gas being able to be generated at the output of the pulse generator by a second voltage, the absolute value of which is smaller than the first voltage, being able to be applied via the output (9) of the pulse generator and at inputs of a plasma source,
***characterised in that**,*
in order to generate the pulse, an output of a first direct voltage source (1) and an output of a second direct voltage source (2, 4) can be connected in a controlled manner to the output of the pulse generator.

2. Pulse generator according to claim 1, further **characterised in that**, after the constant current phase, preferably immediately after the constant current phase or after a switch-off phase following the constant current phase, preferably immediately, and before a next switch-on phase, a cooling phase can be generated, in which no current flows through the plasma or gas and/or **in that** two or more successive pulses with a switch-on phase, a constant current phase and preferably a switch-off phase and/or a cooling phase can be generated.

3. Pulse generator according to one of the preceding claims, further **characterised in that** the second direct voltage generation source is a voltage transformer (2), connected to a capacitance (4).

4. Pulse generator according to one of the preceding claims, further **characterised by** at least one capacitance which is disposed connected in parallel to an output of the first direct voltage source, preferably the capacitance having at least one capacitor (4) or being a capacitor, and/or by at least one capacitance which is disposed connected in parallel to a second output of the second direct voltage source, the capacitance preferably having at least one capacitor (5) or being a capacitor.

5. Pulse generator according to one of the claims 3 or 4, further **characterised in that** an input of the voltage transformer (2) is connected in parallel to an output of the first direct voltage source.

6. Pulse generator according to one of the claims 3 to 5, further **characterised by** at least one current limiter (3) which is disposed directly at the output of the first direct voltage source.

7. Pulse generator according to one of the preceding claims, further **characterised by** a first switch (7) which is disposed behind an output of the first direct voltage source and/or is disposed such that, by closing the first switch, the output of the first direct voltage generation device can be connected to the output of the pulse generator
and/or
by a second switch (6) which is disposed behind the output of the second direct voltage source and/or is disposed such that, by closing the second switch, the output of the second direct voltage generation device can be connected to the output of the pulse generator and/or by a third switch (16) which is disposed between the anode (11) and the cathode (8) of the output of the pulse generator such that the anode and the cathode can be connected together electrically via the third switch, preferably the third switch being connected in series to at least one resistance (17) via which the anode and the cathode can be connected by closing the third switch, and/or by at least one pole-reversal switch (20) between the anode and the cathode of the output of the pulse generator, with which the voltage between the anode and the cathode can be reversed with respect to polarity.

8. Pulse generator according to one of the preceding claims, further **characterised by** at least one current measuring device (10) which is disposed in front of an anode and/or in front of a cathode of the output of the pulse generator such that a current through the anode and/or the cathode can be measured therewith and/or, by at least one voltage measuring device (15) which is disposed between the anode and the cathode of the output of the pulse generator such that, with the voltage measuring device, a voltage between the anode and the cathode of the output of the pulse generator can be measured, and/or by at least one emission measuring device (18) which is fitted and/or disposed such that electromagnetic radiation, preferably optical radiation, which is emitted by a plasma generated by means of the pulse generator, can be measured therewith.

9. Pulse generator according to one of the preceding claims, further **characterised by** at least one control device (13) with which one or more elements, selected from the group having the first switch, the second switch, the third switch, the first direct voltage generation device and the second direct voltage generation device, can be controlled, preferably by at least one synchronous pulse being able to be generated with the control device and with which the corresponding element or elements can be controlled, and by at least one measuring device (10, 15, 18) with which at least one measuring value of the current measuring device, of the voltage measuring device and/or of the emission measuring device can be recorded, preferably at least one element being controllable with the control device, based on at least one of the measuring values recorded by the measuring device.

10. Method for exciting and/or generating a plasma by means of at least one electrical pulse, there being applied, in a switch-on phase lasting for a first time, to the plasma or to a gas for generating the plasma, a first voltage in order to generate a rapid increase in the intensity of a current through the plasma, and there being applied, in a constant current phase following the switch-on phase, to the plasma, a second voltage the absolute value of which is smaller than the first voltage in order to generate an essentially constant current through the plasma, **characterised in that**, in order to generate the pulse, an output of a first direct voltage source and an output of a second direct voltage source are connected in a controlled manner to the output of the pulse generator.

11. Method according to one of the two preceding claims, further **characterised in that** the constant current phase immediately follows the switch-on phase or **in that**, between the switch-on phase and the constant current phase, a time of at most 100 µs, preferably at most 50 µs, preferably at most 30 µs, preferably at most 20 µs, preferably at most 10 µs, preferably at most 5 µs elapses.

12. Method according to one of the claims 10 and 11, further **characterised in that** the constant current phase only lasts so long that a temperature increase or an undesired temperature increase during the constant current phase essentially does not lead to a change in the plasma and/or **in that** the switch-off phase is as short as possible, preferably shorter than or of equal length to the switch-on phase.

13. Method according to one of the claims 10 to 12, further **characterised in that**, between respectively two pulses, a cooling phase, during which no voltage is applied to the plasma or to the gas for generating the plasma, and during which no current flows through the plasma, is implemented, the duration of the cooling phase being chosen preferably such that a target surface, from which sputtering takes place, has a temperature at the end of the cooling phase which is essentially the same as or precisely equal to the temperature of the target surface immediately before the beginning of the preceding switch-on phase.

14. Method according to one of the claims 10 to 13, further **characterised in that** the method is implemented in a pulse sputtering method, preferably in a high-power pulse magnetron sputtering method (HPPMS method) and/or **in that** a large number of pulses is generated.

15. Sputtering plant, **characterised by** a pulse generator according to one of the claims 1 to 9 and/or **characterised in that** a method according to one of the claims 10 to 14 can be implemented therewith.

## Revendications

1. Générateur d'impulsions pour installations de pulvérisation cathodique, qui permet de générer une impulsion électrique, au cours de laquelle, pendant une phase de mise en marche durant un premier temps, une augmentation rapide d'un courant, qui est généré par le générateur d'impulsions à la sortie dudit générateur d'impulsions, peut être produite par un plasma ou un gaz, en appliquant, pendant la phase de mise en marche, une première tension par l'intermédiaire de la sortie du générateur d'impulsions, et, dans une phase de courant constant succédant à la phase de mise en marche, un courant sensiblement constant peut être généré par le plasma ou le gaz à la sortie du générateur d'impulsions, en appliquant une deuxième tension, qui est inférieure en valeur absolue à la première tension, par l'intermédiaire de la sortie (9) du générateur d'impulsions et aux entrées d'une source de plasma,
**caractérisé en ce que**,
pour générer l'impulsion, une sortie d'une première source de courant continu (1) et une sortie d'une deuxième source de courant continu (2, 4) peuvent être connectées de manière contrôlée à la sortie du générateur d'impulsions.

2. Générateur d'impulsions selon la revendication 1, **caractérisé en outre en ce que**, après la phase de courant constant, de préférence immédiatement après la phase de courant constant ou après une phase de mise à l'arrêt succédant, de préférence immédiatement, à la phase de courant constant, et avant une phase de mise en marche suivante, une phase de refroidissement peut être générée, dans laquelle aucun courant ne s'écoule à travers le plasma ou le gaz et/ou **en ce que** deux impulsions successives ou plus peuvent être générées avec une phase de mise en marche, une phase de courant constant et, de préférence, une phase de mise à l'arrêt et/ou une phase de refroidissement.

3. Générateur d'impulsions selon l'une des revendications précédentes, **caractérisé en outre en ce que** la deuxième source de génération de tension continue est un convertisseur de tension (2) relié à une capacité (4).

4. Générateur d'impulsions selon l'une des revendications précédentes, **caractérisé en outre par** au moins une capacité connectée en parallèle à une sortie de la première source de tension continue, la capacité, de préférence, comprenant au moins un condensateur (4) ou étant un condensateur et/ou par au moins une capacité connectée en parallèle à une deuxième sortie de la deuxième source de tension continue, la capacité, de préférence, comprenant au moins un condensateur (5) ou étant un condensateur.

5. Générateur d'impulsions selon l'une des revendications 3 ou 4, **caractérisé en outre en ce qu'**une entrée du convertisseur de tension (2) est connectée en parallèle à une sortie de la première source de tension continue.

6. Générateur d'impulsions selon l'une des revendications 3 à 5, **caractérisé en outre par** au moins un limiteur de courant (3), qui se trouve immédiatement à la sortie de la première source de tension continue.

7. Générateur d'impulsions selon l'une des revendications précédentes, **caractérisée en outre par** un première interrupteur (7), qui est disposé derrière une sortie de la première source de tension continue et/ou disposé de façon à ce que la fermeture du premier interrupteur permette de relier la sortie du premier dispositif de génération de tension continue avec la sortie du générateur d'impulsions
et/ou
par un deuxième interrupteur (6) qui est disposé derrière la sortie de la deuxième source de tension continue et/ou disposé de façon à ce que la fermeture du deuxième interrupteur permette de relier la sortie du deuxième dispositif de génération de tension continue avec la sortie du générateur d'impulsions et/ou par un troisième interrupteur (16), qui est disposé entre l'anode (11) et la cathode (8) de la sortie du générateur d'impulsions de façon à ce que l'anode et la cathode peuvent être reliées électriquement entre elles par l'intermédiaire du troisième interrupteur, le troisième interrupteur étant de préférence branché en série avec au moins une résistance (17) qui permet de relier l'anode et la cathode grâce à la fermeture du troisième interrupteur et/ou par au moins un inverseur de pôles (20) entre l'anode et la cathode de la sortie du générateur d'impulsions, qui permet d'inverser la tension entre l'anode et la cathode.

8. Générateur d'impulsions selon l'une des revendications précédentes, **caractérisée en outre par** au moins un dispositif de mesure de courant (10), qui est disposée avant une anode et/ou avant une cathode de la sortie du générateur d'impulsions de façon à pouvoir mesurer une intensité de courant dans l'anode et/ou la cathode et/ou par au moins un dispositif de mesure de la tension (15), disposé entre l'anode et la cathode de la sortie du générateur d'impulsions de façon à ce que, avec le dispositif de mesure de la tension, une tension entre l'anode et la cathode de la sortie du générateur d'impulsions peut être mesurée et/ou par au moins un dispositif de mesure d'émissions (18) qui est configuré et/ou disposé de façon à pouvoir mesurer un rayonnement électromagnétique, de préférence un rayonnement optique, émis par un plasma généré à l'aide du générateur d'impulsions.

9. Générateur d'impulsions selon l'une des revendications précédentes, **caractérisée en outre par** au moins un dispositif de commande (13), avec lequel un ou plusieurs éléments, sélectionnés parmi le groupe comprenant le premier interrupteur, le deuxième interrupteur, le troisième interrupteur, le premier dispositif de génération de tension continue et le deuxième dispositif de génération de tension continue, peuvent être commandés, de préférence du fait que le dispositif de commande peut générer au moins une impulsion synchrone, avec laquelle l'élément ou les éléments correspondant(s) peuvent être commandé(s), et par au moins un dispositif de mesure (10, 15, 18) avec lequel au moins une valeur de mesure du dispositif de mesure de courant, du dispositif de mesure de tension et/ou du dispositif de mesure d'émissions peut être enregistrée, de préférence au moins un élément pouvant être commandé avec le dispositif de commande sur la base d'au moins une des valeurs de mesure enregistrées par le dispositif de mesure.

10. Procédé d'excitation et/ou de génération d'un plasma par au moins une impulsion électrique, une première tension pour la génération d'une augmentation rapide de l'intensité d'un courant à travers le plasma étant appliquée au plasma ou à un gaz pour la génération du plasma, dans une phase de mise en marche durant un premier temps, et, dans une phase de courant constant succédant à la phase de mise en marche, une deuxième tension, inférieure en valeur absolue à la première tension, est appliquée, pour la génération d'un courant sensiblement constant dans le plasma, est appliquée au plasma, **caractérisé en ce que**, pour la génération de l'impulsion, une sortie d'une première source de tension continue et une sortie d'une deuxième source de tension continue sont reliées de manière contrôlée à la sortie du générateur d'impulsions.

11. Procédé selon l'une des deux revendications précédentes, **caractérisé en outre en ce que** la phase de courant constant succède immédiatement à la phase de mise en marche ou **en ce que**, entre la phase de mise en marche et la phase de courant constant, un temps de 100 µs maximum, de préférence 50 µs maximum, de préférence 30 µs maximum, de préférence 20 µs maximum, de préférence 10 µs maximum, de préférence 5 µs maximum, s'écoule.

12. Procédé selon l'une des revendications 10 et 11, **caractérisé en outre en ce que** la phase de courant constant dure seulement aussi longtemps qu'une augmentation de température ou une augmentation de température indésirable ne provoque sensiblement pas de modification du plasma pendant la phase de courant constant et/ou **en ce que** la phase de mise à l'arrêt est la plus courte possible, de préférence plus courte ou égale à la phase de mise en marche.

13. Procédé selon l'une des revendications 10 à 12, **caractérisé en outre en ce que**, entre deux impulsions, une phase de refroidissement, pendant laquelle aucune tension n'est appliquée au plasma ou au gaz pour la génération du plasma, et pendant laquelle aucun courant ne s'écoule à travers le plasma, est exécutée, la durée de la phase de refroidissement étant choisie de préférence de façon à ce qu'une surface cible, à partir de laquelle la pulvérisation est effectuée, ait, à la fin de la phase de refroidissement, une température qui est sensiblement égale ou exactement égale à la température de la surface cible immédiatement avant le début de la phase de mise en marche précédente.

14. Procédé selon l'une des revendications 10 à 13, **caractérisé en outre en ce que** le procédé est effectué comme un procédé de pulvérisation par impulsions, de préférence comme un procédé « High Power Pulse Magnetron Sputter » ou procédé de pulvérisation à magnétron à impulsions haute puissance (procédé HPPMS) et/ou **en ce qu'**une pluralité d'impulsions sont générées.

15. Installation de pulvérisation cathodique **caractérisée par** un générateur d'impulsions selon l'une des revendications 1 à 9 et/ou **caractérisée en ce qu'**elle permet d'effectuer un procédé selon l'une des revendications 10 à 14.
